# EUROPEAN PATENT APPLICATION

(11) **EP 2 602 816 A1**
(43) Date of publication of application: **12.06.2013**
(21) Application number: 11814638.0
(22) Date of filing: 02.08.2011
(51) Int. Cl.: H01L 21/683

(54) **SUPPORT SUBSTRATE**

(30) Priority: 06.08.2010 JP 2010177746
(71) Applicant: Asahi Glass Company, Limited, Tokyo 100-8405 (JP)
(72) Inventor: FURUKAWA Kazuya, Tokyo 100-8405 (JP); NISHIHARA Yoshiyuki, Tokyo 100-8405 (JP)
(74) Representative: Müller-Boré & Partner Patentanwälte
(86) International application number: PCT/JP2011/067679
(87) International publication number: WO 2012/018013

(57) **Abstract**

This invention relates to a support substrate that is to be attached to a substrate to be supported to thereby support the substrate to be supported, including: a support substrate main body having an attachment surface that is to be attached to the substrate to be supported; and a conductive film mainly including a fluorine-doped tin oxide, which has been formed on at least a surface opposite to the attachment surface among surfaces of the support substrate main body.

## Description

### TECHNICAL FIELD

The present invention relates to a support substrate that supports a substrate such as a semiconductor wafer. Particularly, it relates to a support substrate capable of fixing through electrostatic adsorption.

### BACKGROUND OF THE INVENTION

Recently, with advances in functions of cellular phones, digital AV devices, IC cards, and the like, there have been increasing demands for miniaturization, thinning, and higher integration of semiconductor (silicon) chips to be mounted.
Therefore, in a semiconductor substrate, further thinning of the thickness has been required and hence back grind has been performed, where the back surface of the semiconductor substrate on which an electronic circuit has been formed is ground using a grinder. Moreover, after a thin film such as an oxidized film has been formed on the semiconductor substrate, a photoresist has been applied thereon, and subsequently a pattern exposition has been performed, an unnecessary thin film has been removed by dry etching such as plasma treatment.

In the grinding step and dry etching step of the semiconductor substrate, since temperature of the substrate is unduly elevated by frictional heat resulting from grinding, plasma irradiation, and the like, there is a concern that a device (electronic circuit) formed on the substrate is damaged.
Therefore, during the grinding step or the like of the substrate, it is required to perform the step with fixing it to a substrate-supporting stand excellent in cooling performance. As a method for fixing to the substrate-supporting stand, there may be mentioned a so-called electrostatic chuck method wherein a substrate is electrostatically adsorbed by transferring movable ions with applying voltage to the substrate.

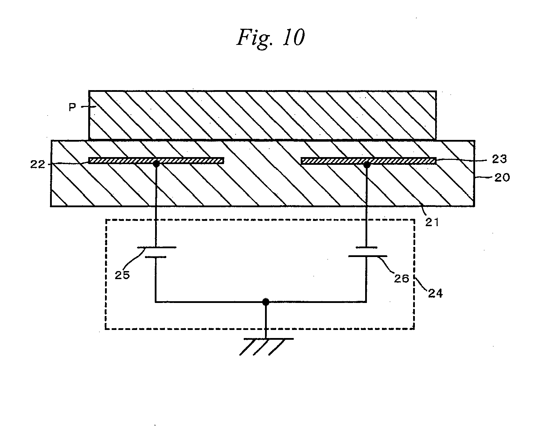

The electrostatic chuck method is specifically, for example, as shown in Fig. 10, a method of applying voltage to electrodes 22, 23 provided in an insulator 21 such as ceramics from an adsorption power source 24 composed of direct-current power sources 25, 26 to generate positive and negative electric charges between a substrate P that is an object to be adsorbed and the above electrodes 22, 23 and adsorbing and holding the substrate P to a holder (hereinafter also referred to as electrostatic chuck) by electrostatic force (for example, Coulomb force) that acts between them (see, for example, Patent Document 1).

In these steps (substrate-grinding step, dry etching step), a support substrate such as glass or hard plastic is attached to the substrate to be ground, etched, or the like to maintain strength of the substrate. Thereby, generation of cracks and warps on the semiconductor substrate to be ground can be prevented.

However, in an insulating substrate such as a glass substrate, since movable ions present in the substrate are few, the substrate cannot be sufficiently fixed by the electrostatic chuck method in some cases. Therefore, it has been proposed to provide (1) a film which generates polarization of electric field by applying electric field, (2) a film having electric conductivity, or the like on one surface of a support substrate composed of an insulating substrate (see, for example, Patent Document 2).

### BACKGROUND ART

### Patent Document

[Patent Document 1] JP-A-6-334024
[Patent Document 2] JP-A-2000-208594

### SUMMARY OF THE INVENTION

### PROBLEMS THAT THE INVENTION IS TO SOLVE

As the film having electric conductivity, for example, a conductive film composed of tin-doped indium oxide (hereinafter referred to as ITO film) has been used. However, the ITO film has low durability against chemicals or the like and deterioration of the film is prone to occur. When the deterioration of the film proceeds, there is a concern that a periphery part of the support substrate main body is etched to form a gap between the support substrate main body and the film and the semiconductor substrate cannot be stably supported.
Moreover, at re-use of the support substrate, when the deterioration of the film is generated by a chemical for use in surface washing, it becomes necessary to form the film again on the support substrate main body, so that there is a concern that effective recycle is inhibited.

The present invention is devised for solving the above problems and an object thereof is to provide a support substrate which is capable of adsorbing and holding by an electrostatic chuck, can suppress the thermal damage of the substrate to be supported, which is to be ground or the like, and is excellent in durability.

### MEANS FOR SOLVING THE PROBLEMS

That is, a support substrate of the present invention is the support substrate that is to be attached to a substrate to be supported to thereby support the substrate to be supported, comprising:
a support substrate main body having an attachment surface that is to be attached to the substrate to be supported; and
a conductive film mainly comprising a fluorine-doped tin oxide, which has been formed on at least a surface opposite to the attachment surface among surfaces of the support substrate main body.

Also, in the support substrate, it is preferable that all the surfaces of the support substrate main body are covered with the conductive film. Moreover, it is preferable that the conductive film has a thickness of 5 nm to 2 µm. Moreover, it is preferable that an edge surface of the support substrate main body has a curvature radius R of 50 to 800 µm. Furthermore, it is preferable that the conductive film has a sheet resistance of 100 kΩ/□ or less.

### ADVANTAGE OF THE INVENTION

According to the invention, by providing an conductive film mainly comprising fluorine-doped tin oxide on a surface of the support substrate main body, there can be realized a support substrate that makes it possible to be adsorbed and be held to a grinding machine or the like by an electrostatic chuck, is capable of suppressing thermal damage of a substrate to be supported, which is to be ground or etched, and is excellent in durability.

### BRIEF DESCRIPTION OF THE DRAWINGS

Fig. 1 is a cross-sectional view showing one example of the support substrate of the invention.
Fig. 2 is a cross-sectional view showing a state where the support substrate of the invention has been attached to a semiconductor wafer to be supported by the support substrate.
Fig. 3 is a cross-sectional view showing one example of a support substrate main body to be applied to the support substrate of the invention.
Fig. 4 is a perspective view showing one example of the support substrate of the invention.
Fig. 5 is a cross-sectional view showing one example of the support substrate of the invention.
Fig. 6 is a perspective view showing one example of a semiconductor wafer to be supported by the support substrate of the invention.
Fig. 7 is a perspective view showing a state where a semiconductor wafer is attached to a support substrate main body.
Fig. 8 is a perspective view showing a state where a semiconductor wafer has been attached to a support substrate main body.
Fig. 9 is a perspective view showing one example of a grinding apparatus for use in a grinding step of a semiconductor wafer that has been supported by the support substrate of the invention.
Fig. 10 is a view showing one example of a method for adsorbing and holding a substrate.

### MODE FOR CARRYING OUT THE INVENTION

The following will describe the invention in detail.
The invention relates to a support substrate that is to be attached to a substrate to be supported to thereby support the substrate to be supported, comprising a support substrate main body having an attachment surface that is to be attached to the substrate to be supported; and a conductive film mainly comprising a fluorine-doped tin oxide (hereinafter referred to as FTO), which has been formed on at least a surface opposite to the attachment surface among surfaces of the support substrate main body.

According to the invention, by forming the conductive film mainly comprising FTO on at least the surface opposite to the attachment surface among surfaces of the support substrate main body, it becomes possible to achieve adsorbing and holding to a grinding machine or the like by an electrostatic chuck. Therefore, a damage of the substrate to be supported owing to heat resulting from grinding treatment, dry etching treatment, and the like can be suppressed. Moreover, by forming the conductive film mainly comprising FTO, durability is enhanced and recycle performance can be improved.

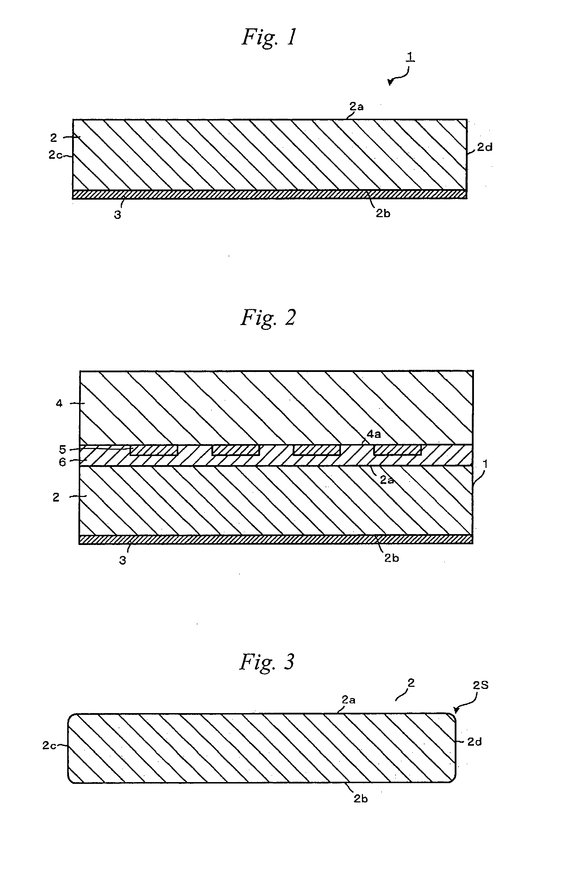

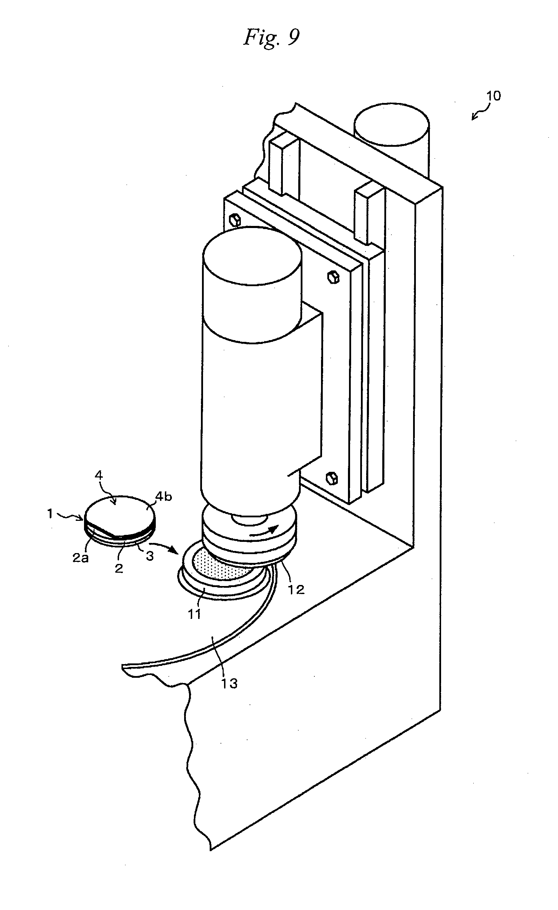

Fig. 1 is a cross-sectional view showing one example of the support substrate of the invention and Fig. 2 is a cross-sectional view showing a state where the support substrate of the invention has been attached to a semiconductor wafer to be supported by the support substrate.
The support substrate 1 has an almost plate-shaped support substrate main body 2. In the support substrate main body 2, one main surface is an attachment surface 2a to be attached to a substrate to be supported (hereinafter referred to as semiconductor wafer) 4 such as a semiconductor wafer. Moreover, another main surface, which is opposite to the attachment surface 2a, is a holding surface 2b to be held on a substrate-supporting stand 11 (see Fig. 9) in a grinding step or the like and an conductive film 3 is provided so as to cover the whole holding surface 2b.
The support substrate 1 supports the semiconductor wafer 4 through attachment of a device formation surface 4a of the semiconductor device 4 on the attachment surface 2a using an adhesive 6, for example, as shown in Fig. 2.

The conductive film 3 is a film for enabling adsorption and support of the support substrate 1 by the electrostatic chuck and is mainly composed of FTO.
Incidentally, the conductive film 3 is not limited to one formed of FTO alone and may contain, for example, a film composed of FTO and an intermediate film, one corresponding to the intermediate layer, or the like for improving adhesiveness to the support substrate 1.

The thickness of the conductive film 3 is preferably 5 nm or more, more preferably 50 nm or more, and further preferably 100 nm or more. The thickness is preferably 2 µm or less and particularly preferably 1 µm or less.
When the thickness of the conductive film 3 is less than 5 nm, there is a concern that the effect of then electrostatic adsorption is not sufficiently obtained and also there is a concern that sufficient durability is not obtained. On the other hand, when the thickness of the conductive film 3 exceeds 2 µm, time required for film formation increases and there is a concern that productivity decreases.

The sheet resistance of the conductive film 3 is preferably 100 kΩ/□ or less. It is more preferably 10 kΩ/□ or less. It is most preferably 1000 Ω/□ or less.
When the sheet resistance of the conductive film 3 exceeds 100 kΩ/□, the effect of the electrostatic adsorption is not sufficiently obtained and there is a concern that adsorptive holding is not achieved by the electrostatic chuck.

A material for the support substrate main body 2 is not particularly limited as far as it has strength capable of supporting the semiconductor wafer 4 to be ground, etching, or the like but, for example, glass, metal, ceramics, silicon, or the like can be used. Of these, particularly from the viewpoint of optical transparency, glass is suitably used.

Moreover, in the support substrate main body 2, for example, as shown in Fig. 3, an edge surface 2S of its peripheral part is suitably formed in an arc form and radius R of curvature of the edge surface 2S is preferably 50 to 800 µm. When the radius R of curvature of the edge surface 2S of the support substrate main body 2 is less than 50 µm, for example, in the case where the conductive film 3 is provided on side surfaces 2c, 2d, and the like together with the holding surface 2b of the support substrate main body 2, there is a concern that the conductive film 3 cannot be formed in an even thickness. On the other hand, when the radius R of curvature of the edge surface 2S of the support substrate main body 2 exceeds 800 µm, there is a concern that mechanical strength of the peripheral part decreases.

The thickness of the support substrate main body 2 is not particularly limited but is preferably 300 to 1000 µm from the viewpoint of stably supporting the semiconductor wafer 4.
When the thickness of the support substrate main body 2 is less than 300 µm, handling properties are poor and there is a concern that a yield rate as a support substrate decreases due to a decrease in durability or the like. On the other hand, when the thickness of the support substrate main body 2 exceeds 1000 µm, there is a concern that production cost becomes unduly high and the case is disadvantageous in view of cost price.

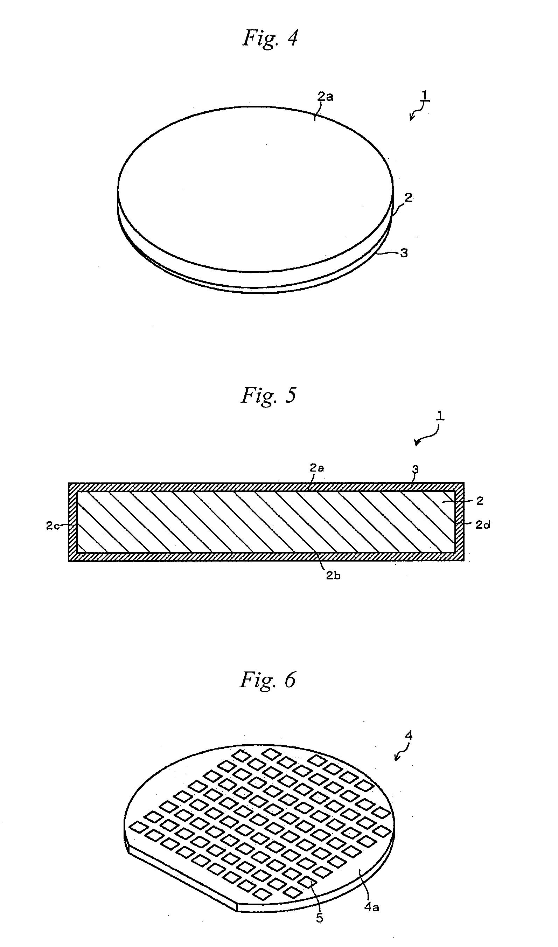

The support substrate 1 may have a disk shape, a rectangular shape such as a square shape, a polygonal shape, or the like, and the shape is not particularly limited as long as it can support the semiconductor wafer 4. From the viewpoint of stably supporting the whole surface of the semiconductor wafer 4, the substrate has preferably the same shape as that of the semiconductor wafer 4. Since the semiconductor wafer 4 is usually formed in a disk shape, for example, as shown in Fig. 4, the shape of the support substrate 1 is also preferably a disk shape.

The size of the support substrate 1 is not particularly limited but, from the viewpoint of stably supporting the semiconductor wafer 4, the size is preferably the same as that of the semiconductor wafer 4 or about 0.1 to 0.5 mm larger than the outer size of the semiconductor wafer 4.

In Fig. 1, a support substrate 1 formed only on the holding surface 2b among the surfaces of the support substrate main body 2 is shown but the conductive film 3 is preferably formed not only on the holding surface 2b but also on the side surfaces 2c, 2d or the attachment surface 2a of the support substrate main body 2. From the viewpoint of improving the durability of the support substrate 1, it is suitable that the conductive film 3 is formed over all the surfaces (see Fig. 5) of the support substrate main body 2.

Since FTO composing the conductive film 3 is excellent in acid resistance, even in the case where the support substrate main body 2 mainly comprises, for example, glass, proceeding of corrosion by a strongly acidic chemical agent such as hydrogen fluoride can be suppressed and the durability of the support substrate 1 can be improved by covering all the surfaces of the support substrate main body 2 with the conductive film 3 mainly comprising FTO (see Fig. 5).

As above, the support substrate 1 of the invention is explained with reference to one example but can be suitably changed unless it contradicts the gist of the invention and also according to need.

The support substrate 1 of the invention can be formed as a film on the holding surface 2b of the aforementioned support substrate main body 2 by, for example, a spray pyrolysis deposition method (SPD method), a chemical vapor deposition method (CVD method), a Dip method, a sputtering method, a sol-gel method, a pyrosol process, or the like of a raw material of the conductive film 3. Of these, the SPD method is preferred since a conductive film 3 having an even thickness can be formed at low costs.

The SPD method is one of thin-film formation methods, wherein a starting material solution is sprayed onto a heated substrate and an oxide formed by a pyrolysis reaction induced on the substrate is allowed to grow on a surface of the substrate. Since a reduced-pressure atmosphere is unnecessary and apparatus configuration is simple, production costs can be suppressed.
In the case where the SPD method is employed for the formation of the conductive film 3, the conductive film 3 can be formed by spraying a mixed solution, which has been obtained by mixing an ethanol solution of tin chloride hydrate and an ammonium fluoride solution as starting materials, onto the attachment surface 2a of the support substrate main body 2 by means of a sprayer.

In the case of forming the conductive film 3 by the SPD method, for example, conditions of concentration of the raw material solution, spraying pressure of the raw material solution, flow rate at spraying, temperature of the support substrate main body, and the like can be suitably selected.

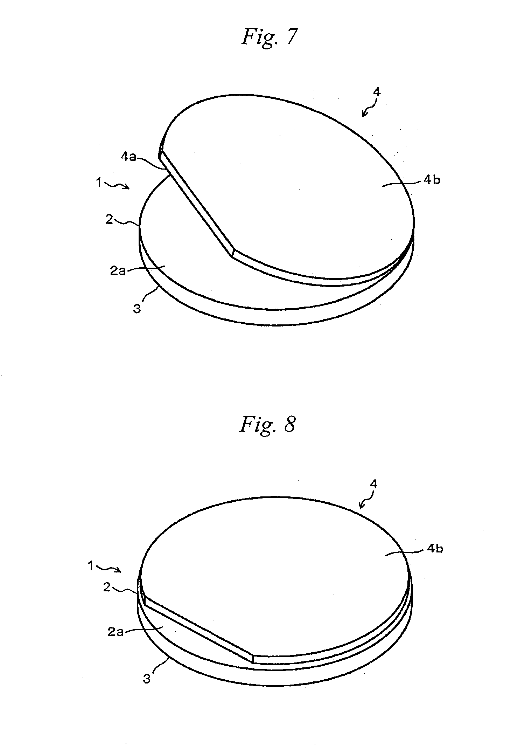

The support substrate 1 thus obtained can be used in an integrated form by facing the device formation surface 4a (see Fig. 6) of the semiconductor wafer 4 and the attachment surface 2a of the support substrate main body 2 each other and attaching the attachment surface 2a to the device formation surface 4a with an adhesive or the like, for example, as shown in Figs. 7 and 8.

The semiconductor wafer 4 integrated with the support substrate 1 can be placed by holding the conductive film 3 of the support substrate 1 with a substrate-supporting stand 11 of a grinding apparatus 10, for example, as shown in Fig. 9. Thereby, an exposed surface 4b opposite to the device formation surface 4a is ground with confronting with a grinding whetstone 12.

Incidentally, as the adhesive, a resin material such as acrylic, ester-based, urethane-based, epoxy-based, or silicone-based one can be used.

Since the conductive film 3 mainly comprising FTO is provided on the holding surface 2b, the support substrate 1 of the invention can be adsorbed and supported by the electrostatic chuck (holder) 20 as shown in Fig. 10, for example.

Specifically, voltage for adsorption is applied from the adsorption power source 24 to the electrodes 22, 23 to generate positive and negative electron charges between the conductive film 3 on the insulator 21 and the electrodes 22, 23. By electrostatic force that acts between them, the support substrate 1 is adsorbed and held on the insulator 21.

According to the support substrate of the invention, the conductive film 3 enables adsorbing and holding by the electrostatic chuck and a cooling function intrinsic to the apparatus can be sufficiently exhibited by close adhesion of the insulator 21 to the supported substrate. Thereby, undue temperature elevation of the substrate to be supported 4, which is subjected to grinding treatment and dry etching treatment, can be suppressed, so that thermal damage of the substrate to be supported 4 can be suppressed.

Moreover, since durability of the conductive film 3 is enhanced by forming the conductive film 3 as a film mainly comprising FTO, the proceeding of corrosion with a chemical agent is little even when surface washing is performed in a state that the conductive film 3 has been provided and thus a support substrate having improved recycle performance can be realized.

Incidentally, in the aforementioned process for producing the support substrate 1, forming order of the respective parts and the like can be also suitably changed within a limit where the production of the support substrate 1 is possible.

### EXAMPLES

The following will describe the invention in further detail with reference to Examples.

### (Example 1)

First, a raw material solution for a conductive film composed of FTO (hereinafter referred to as FTO film) was prepared. Namely, tin (IV) chloride pentahydrate was dissolved in ethanol and then a mixture obtained by adding a saturated aqueous ammonium fluoride solution to the solution was subjected to an ultrasonic cleaner to achieve complete dissolution, thereby obtaining a raw material solution for FTO film.

After one main surface of a glass substrate (diameter: 150 mm, thickness: 0.7 mm) was washed with liquid and then dried, the glass substrate was placed in a sprayer and heated to 500°C by means of a heater. The raw material solution for FTO film was sprayed onto the liquid-washed surface of the glass substrate for a predetermined time from a nozzle of the sprayer to form an FTO film having a thickness of 200 nm on one main surface of the glass substrate, thereby producing a support substrate 1.

### (Example 2)

A support substrate 1 was produced in the same manner as in Example 1 except that the raw material solution for FTO film was sprayed onto all the surfaces of the glass substrate to form an FTO film.

### (Comparative Example 1)

A support substrate 1 was produced in the same manner as in Example 1 except that any FTO film was not formed on the surface of the glass substrate main body 1.

### (Comparative Example 2)

A support substrate 1 was produced in the same manner as in Example 1 except that a raw material solution for a conductive film composed of ITO (hereinafter referred to as ITO film) was used instead of the raw material solution for FTO film.

In this regard, the raw material solution for ITO film was prepared by dissolving indium(III) chloride tetrahydrate and tin(II) chloride dihydrate in ethanol.

Then, the support substrate 1 of each of Examples and Comparative Examples was placed on the insulator 21 shown in Fig. 10 and a voltage of DC 500 V was applied to the adsorption power source 24. The support substrate 1 was drawn in a circumferential direction until measured strength by means of a push-pull gauge reached 4.9 N (500 gf). On this occasion, a case where the support substrate 1 and the insulator 21 were not exfoliated was marked "O" and a case where they were exfoliated was marked "x" in Table 1.
Incidentally, the contact surface with the insulator 21 was the FTO film in Example 1, was the ITO film in Comparative Example 2, and was any surface of the support substrate 1 in Example 2 and Comparative Example 1.

All the surfaces of the support substrate 1 was dipped in a 10 mass% hydrofluoric acid (HF) solution for 24 hours and a degree of decrease of the FTO film or the ITO film and a degree of decrease of the glass substrate were measured using ICP-MS (ICP Mass Spectrometry (Inductive Coupled Plasma-Mass Spectrometry)), thereby evaluating durability.

For the support substrate 1 of each of Examples and Comparative Examples, presence or absence of adsorption by the electrostatic chuck and evaluation results on durability are shown in Table 1. In Table 1, the degree of decrease of the FTO film or the ITO film (referred to as degree of film decrease in Table 1) and the degree of decrease of the glass substrate (referred to as degree of glass decrease in Table 1) were evaluated after each was converted into thickness.

**[Table 1]**

| | Mounting surface of conductive film 3 | Kind of conductive film | Presence or absence of adsorption by electrostatic chuck | Durability | |
|---|---|---|---|---|---|
| | | | | Degree of film decrease | Degree of glass decrease |
| Example 1 | Holding surface 2b | FTO | O | 0.01 µm or less | 50 µm or more |
| Example 2 | all surfaces | FTO | O | 0.01 µm or less | None |
| Comparative Example 1 | None | - | × | - | 100 µm or more |
| Comparative Example 2 | Holding surface 2b | FTO | o | 1 µm or less | 100 µm or more |

As apparent from Table 1, the support substrate 1 of Comparative Example 1 wherein no FTO film had been provided was not adsorbed and held by the electrostatic chuck. Moreover, the support substrate of Comparative Example 2 was able to be adsorbed and held by the electrostatic chuck but was poor in durability, and deterioration of the conductive film 3 after chemical washing was observed.
On the other hand, the support substrate of Example 1 wherein the FTO film had been formed on one surface of the glass substrate was able to be adsorbed and held by the electrostatic chuck and it was observed that the degree of decrease of the FTO film after chemical washing was also low. Moreover, in the support substrate of Example 2 wherein the FTO film had been formed over all the surfaces of the glass substrate, it was observed that the degrees of decrease of the FTO film and the glass substrate after chemical washing were extremely low and thus excellent durability was obtained.

While the present invention has been described in detail with reference to specific embodiments thereof, it will be apparent to one skilled in the art that various changes and modifications can be made therein without departing from the spirit and scope thereof.
Incidentally, the present application is based on Japanese Patent Application No. 2010-177746 filed on August 6, 2010, and the contents are incorporated herein by reference.

### DESCRIPTION OF REFERENCE NUMERALS AND SIGNS

| | |
|---|---|
| 1: | Support substrate, |
| 2: | Support substrate main body, |
| 2a: | Attachment surface, |
| 2b: | Holding surface, |
| 3: | Conductive film, |
| 4: | Substrate to be supported (semiconductor wafer), |
| 4a: | Device formation surface, |
| 5: | Device (circuit), |
| 6: | Adhesive, |
| 10: | Grinding apparatus, |
| 11: | Substrate-supporting stand, |
| 12: | Grinding whetstone, |
| 13: | Turntable, |
| 20: | holder (electrostatic chuck), |
| 21: | Insulator, |
| 22, 23: | Electrodes, |
| 24: | Adsorption power source, |
| 25, 26: | Direct-current power source |

## Claims

1. A support substrate that is to be attached to a substrate to be supported to thereby support the substrate to be supported, comprising:
a support substrate main body having an attachment surface that is to be attached to the substrate to be supported; and
a conductive film mainly comprising a fluorine-doped tin oxide, which has been formed on at least a surface opposite to the attachment surface among surfaces of the support substrate main body.

2. The support substrate according to claim 1, wherein all the surfaces of the support substrate main body are covered with the conductive film.

3. The support substrate according to claim 1 or 2, wherein the conductive film has a thickness of 5 nm to 2 µm.

4. The support substrate according to any one of claims 1 to 3, wherein an edge surface of the support substrate main body has a curvature radius R of 50 to 800 µm.

5. The support substrate according to any one of claims 1 to 4, wherein the conductive film has a sheet resistance of 100 kΩ/□ or less.
